# EUROPEAN PATENT APPLICATION

(11) **EP 4 009 751 A1**
(43) Date of publication of application: **08.06.2022**
(21) Application number: 20868470.4
(22) Date of filing: 24.09.2020
(51) Int. Cl.: H05K 1/02, H05K 1/11

(54) **CIRCUIT BOARD AND COMMUNICATION DEVICE**

(30) Priority: 26.09.2019 CN 201910916145
(71) Applicant: ZTE Corporation, Shenzhen, Guangdong 518057 (CN)
(72) Inventor: LI, Jinlong, Shenzhen, Guangdong 518057 (CN); ZHANG, Xindan, Shenzhen, Guangdong 518057 (CN); YI, Bi, Shenzhen, Guangdong 518057 (CN); WEI, Zhongmin, Shenzhen, Guangdong 518057 (CN)
(74) Representative: Raynor, Simon Mark
(86) International application number: PCT/CN2020/117493
(87) International publication number: WO 2021/057857

(57) **Abstract**

Embodiments of the present invention relate to the field of communication device technology, which provide a circuit board including a first signal line and a second signal line that are disposed adjacent to each other, a ground plane, and a conductive layer connected to the ground plane. The conductive layer is disposed between the first signal line and the second signal line. Embodiments of the present invention further provide a communication device.

## Description

### CROSS REFERENCE TO RELATED APPLICATIONS

The present invention claims priority to Chinese patent application No. 201910916145.9, filed September 26, 2019, which is incorporated by reference herein in its entirety.

### TECHNICAL FIELD

The present invention relates to the field of communication device technology, and in particular to a circuit board and a communication device having the circuit board.

### BACKGROUND

With the advent of the information era, the transmission speed of the signal increases constantly. A speed of a high-speed SerDes (SERializer/DESerializer) has been increased from 25Gbps to 56Gbps, and is increasing to 112Gbps. With such a high speed, there are many design difficulties in implementing high-speed signal wiring throughout the system. In the past, design considerations were typically made at the component level, but a new generation of multi-Gbps designs require an overall analysis of paths of the signal channel. The developer must analyze and improve interactions of all components in the entire channel instead of focusing on just one component. In the process of the analyzing and improving, a crosstalk problem of the communication line is important which cannot be ignored.

### SUMMARY

Embodiments of the present invention provide a circuit board including a first signal line and a second signal line that are disposed adjacent to each other, a ground plane, and a conductive layer connected to the ground plane, where the conductive layer is disposed between the first signal line and the second signal line.

Embodiments of the present invention further provide a communication device including a housing and the circuit board, where the circuit board is disposed in the housing.

### BRIEF DESCRIPTION OF THE DRAWINGS

One or more embodiments are described as examples with reference to the corresponding figures in the accompanying drawings, and the examples do not constitute a limitation to the embodiments. Elements with the same reference numerals in the accompanying drawings represent similar elements. The figures in the accompanying drawings do not constitute a proportion limitation unless otherwise stated.
FIG. 1 is a schematic perspective view showing a structure of a circuit board according to a first embodiment of the present invention;
FIG. 2 is a top view of a circuit board shown in FIG. 1;
FIG. 3 is an electric field distribution diagram of conventional signal lines;
FIG. 4 is an electric field distribution diagram of signal lines according to a first embodiment of the present invention;
FIG. 5 is a schematic perspective view showing a structure of a circuit board according to a modified embodiment of the first embodiment of the present invention;
FIG. 6 is a crosstalk comparison diagram of a conventional signal line and a signal line in the first embodiment of the present invention;
FIG. 7 is a top view of a circuit board according to a second embodiment of the present invention;
FIG. 8 is a top view of a circuit board according to a third embodiment of the present invention;
FIG. 9 is a top view of a circuit board according to a fourth embodiment of the present invention;
FIG. 10 is a top view of a modified structure of a circuit board according to a fourth embodiment of the present invention;
FIG. 11 is a top view of a circuit board according to a fifth embodiment of the present invention; and
FIG. 12 is a structural block diagram of a communication device according to a sixth embodiment of the present invention.

### DETAILED DESCRIPTION

In order to make objectives, technical solutions and advantages of the present invention clearer, embodiments of the present invention will be described below in detail with reference to accompanying drawings and embodiments. It should be understood that, in various embodiments, many technical details are proposed for the reader to better understand the present invention. However, the technical solutions claimed in the present invention may be realized even without these technical details and various changes and modifications based on the following embodiments.

A first embodiment of the present invention relates to a circuit board including a first signal line and a second signal line that are disposed adjacent to each other, a ground plane, and a conductive layer connected to the ground plane. The conductive layer is disposed between the first signal line and the second signal line.

The circuit board is provided with a grounded conductive layer between the first signal line and the second signal line that are disposed adjacent to each other. When a signal propagates on the first signal line, a coupling electric field is formed between the first signal line and the conductive layer that is grounded, so that interference noise generated by the first signal line is transmitted to the grounded conductive layer adjacent to the first signal line, and then transmitted to a ground network via the grounded conductive layer, so that the grounded conductive layer shares the noise interference that would otherwise be concentrated on the second signal line, thereby greatly reducing interference influence on the second signal line and effectively reducing crosstalk problems of the communication line.

The implementation details of a non-contact detection apparatus in this embodiment are described in detail below, and the following contents are merely provided for convenient understanding of the implementation details, which are not necessary for implementing the technical solution.

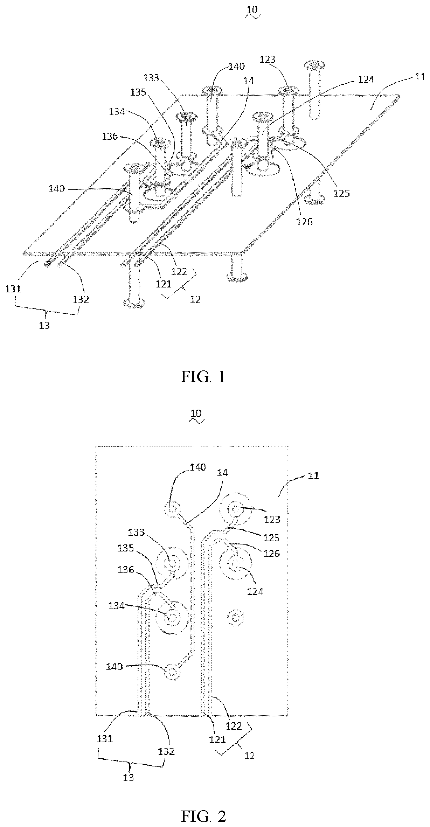

As shown in FIGs. 1 and 2, a circuit board 10 in this embodiment includes a ground plane 11, a first signal line 12, a second signal line 13, and a conductive layer 14.

The ground plane 11 is a conductive metal layer inside the circuit board 10, which is configured to provide a ground to electronic components on the circuit board 10. In this embodiment, the circuit board 10 includes a substrate (not shown) configured to carry the ground plane 11, and a plurality of insulating layers and circuit layers configured to form a circuit connection structure are spaced apart from each other and sequentially stacked above the ground plane 11 on the substrate.

The first signal line 12 is a conductor track formed inside the circuit board 10 and may be formed by etching the circuit layer of the circuit board 10. The first signal line 12 shown in FIG. 1 is disposed above the ground plane 11. In this embodiment, the first signal line 12 includes a transmission line 121 and a transmission line 122 that are spaced apart from each other. A signal via 123 is provided on one side of the transmission line 121, a signal via 124 is provided on one side of the transmission line 122, the transmission line 121 is connected to the signal via 123 through a connection line 125, and the transmission line 122 is connected to the signal via 124 through a connection line 126. Thus, the transmission line 121 and the transmission line 122 communicate with conductor tracks on other circuit layers of the circuit board 10 through the signal via 123 and the signal via 124, respectively, to achieve transmission of electrical signals. In this embodiment, the transmission line 121 and the transmission line 122 are differential signal transmission lines, and the transmission line 121 is parallel to the transmission line 122.

The second signal line 13 is also a conductor track formed inside the circuit board 10, and the second signal line 13 shown in FIG. 1 is also provided above the ground plane 11. In this embodiment, the second signal line 13 includes a transmission line 131 and a transmission line 132 that are spaced apart from each other. A signal via 133 is provided on one side of the transmission line 131, the transmission line 131 is connected to the signal via 133 through a connection line 135. A signal via 134 is provided on one side of the transmission line 132, and the transmission line 132 is connected to the signal via 134 through a connection line 136. Thus, the transmission line 131 and the transmission line 132 communicate with conductor tracks on other circuit layers of the circuit board 10 through the signal via 133 and the signal via 134, respectively, to achieve transmission of electrical signals. In this embodiment, the transmission line 131 and the transmission line 132 are differential signal transmission lines, and the transmission line 131 is parallel to the transmission line 132.

The conductive layer 14, which may be a conductor track electrically connected to the ground plane 11 through a ground via 140, is disposed at the same layer of the circuit board 10 as the first signal line 12. In this embodiment, the conductive layer 14 is parallel to the transmission line 121 and the transmission line 122. Specifically, in this embodiment, there are two ground vias 140, and the two ground vias 140 are located at two side of the conductive layer 14, respectively.

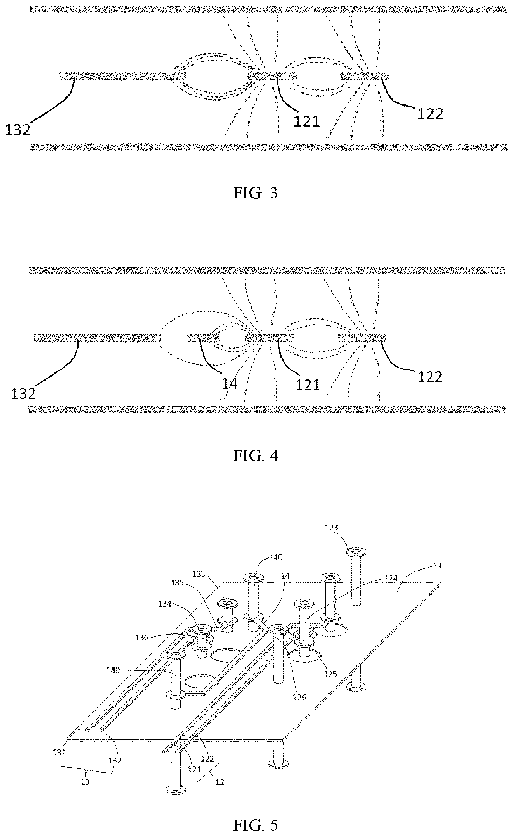

FIG. 3 is an electric field distribution diagram of conventional signal lines. In the signal line design of the existing technology, the two transmission lines 121 and 122 of the first signal line are disposed adjacent to the transmission line 132 of the second signal line, and coupling electric fields (shown by dashed lines in FIG. 3) are formed between the transmission line 121 and the transmission line 132 and between the transmission line 121 and the transmission line 122. Therefore, the interference noise generated by the transmission line 121 is transmitted to the transmission line 132 adjacent to the transmission line 121, thereby causing interference to the transmission line 132 of the second signal line and causing crosstalk of the communication line.

FIG. 4 is an electric field distribution diagram of signal lines according to this embodiment. Since the conductive layer 14 is grounded and disposed between the transmission line 121 of the first signal line 12 and the transmission line 132 of the second signal line 13, a coupling electric field is formed between the transmission line 121 and the grounded conductive layer 14 when the signal propagates on the transmission line 121, so that the interference noise generated by the transmission line 121 is transmitted to the conductive layer 14 adjacent to the transmission line 121, and then transmitted to a ground network via the conductive layer 14, so that the conductive layer 14 shares the noise interference that would otherwise be concentrated on the transmission line 132, thereby greatly reducing the interference influence on the transmission line 132 of the second signal line 13 and effectively reducing the crosstalk problem of the communication line.

It should be noted that the first signal line 12, the second signal line 13, and the conductive layer 14 may be respectively disposed at different layers of the circuit board 10, or any two of them may be disposed at the same layer of the circuit board 10 and the other is disposed at the other layer of the circuit board 10, or all of the them may be disposed at the same layer of the circuit board 10. In this embodiment, the conductive layer 14 and the first signal line 12 are disposed at the same layer, so that the grounded conductive layer 14 and the first signal line 12 are relatively close to each other because they are disposed at the same layer, thereby enhancing the coupling degree between the first signal line 12 and the conductive layer 14, enabling the grounded conductive layer 14 to share more noise interference, and reducing the interference influence on the second signal line 13 to a greater extent.

For example, as shown in FIG. 5, in a modified embodiment, the first signal line 12 and the second signal line 13 are disposed at different layers of the circuit board 10. Specifically, a circuit layer at which the second signal line 13 is disposed is located above the first signal line 12. Thus, in a three-dimensional space in which the circuit board is located, the conductive layer 14 is still disposed between the first signal line 12 and the second signal line 13, so that the conductive layer 14 is still able to share the noise interference, thereby greatly reducing the interference influence on the transmission line 132 of the second signal line 13 and effectively reducing the crosstalk problem of the communication line.

In this embodiment, the conductive layer 14, the first signal line 12, and the second signal line 13 are all disposed at the same layer of the circuit board 10. Since the presence of the conductive layer 14 is able to reduce the degree of interference to which the second signal line 13 is subjected, the second signal line 13 is no longer forced to form on other layers of the circuit board 10 due to the interference, thereby saving the number of wiring layers to reduce the cost. In addition, it should be noted that thicknesses of the conductive layer 14 and the transmission lines 121, 122 may be completely the same (i.e., the thicknesses of all the three layers are the same), partially the same (i.e., the thicknesses of any two of the three layers are the same), or different from each other (i.e., the thicknesses of all the three layers are different), which is not specifically limited herein. In an actual manufacturing process, the thicknesses of the conductive layer 121 and the transmission lines 121 and 122 may be appropriately selected with reference to specific design schemes and manufacturing process requirements. In this embodiment, the thicknesses of the conductive layer 121 and the transmission lines 121 and 122 are the same.

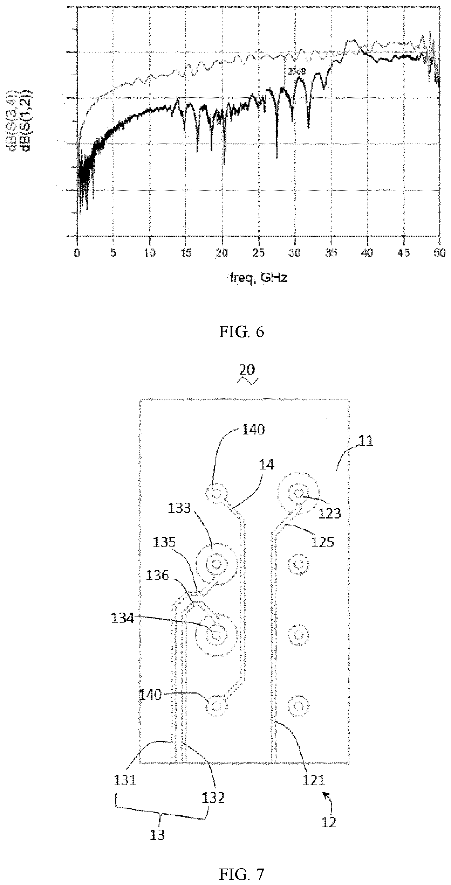

The inventor of the present invention performs crosstalk measurement and comparison on a high-speed board having the above-described structure. In this board, outlet layers of the signal vias of the first signal line and the second signal line are both L8 layers, and a pitch of a ball grid array (BGA) is 1.0 mm. An experimental result is shown in FIG. 6, an upper curve is the crosstalk between the conventional signal lines, and a lower curve is the crosstalk between the signal lines of this embodiment. It is be seen from FIG. 6 that the crosstalk between the signal lines of this embodiment is greatly improved, the crosstalk is reduced by 20 dB at 28 GHz, which ensures the achievement of a product crosstalk index.

A second embodiment of the present invention relates to another circuit board 20. As shown in FIG. 7, the circuit board 20 provided in the second embodiment is substantially the same as the circuit board 10 provided in the first embodiment. The circuit board 20 also includes a ground plane 11, a first signal line 12, a second signal line 13, and a conductive layer 14. The difference is that the first signal line 12 of the second embodiment includes only a single transmission line 121, and in this case, the first signal line 12 changes from the differential signal transmission line in the first embodiment to a single-end signal transmission line.

Specifically, the first signal line 12 includes a single transmission line 121, a signal via 123 is provided on one side of the transmission line 121, and the transmission line 121 is connected to the signal via 123 through a connection line 125, so that the transmission line 121 communicates with conductor tracks on other circuit layers of the circuit board 20 through a conductive pattern 125 and the single signal via 12.

The second signal line 13 is a conductor track formed inside the circuit board 20, and includes a transmission line 131 and a transmission line 132 that are spaced apart from each other. A signal via 133 is provided on one side of the transmission line 131, the transmission line 131 is connected to the signal via 133 through a connection line 135. A signal via 134 is provided on one side of the transmission line 132, and the transmission line 132 is connected to the signal via 134 through a connection line 136. Thus, the transmission line 131 and the transmission line 132 communicate with the conductor tracks on the other line layers of the circuit board 10 through the signal via 133 and the signal via 134, respectively, to achieve transmission of electrical signals. In this embodiment, the transmission line 131 and the transmission line 132 are differential signal transmission lines, and the transmission line 131 is parallel to the transmission line 132.

In this way, the conductive layer 132 disposed between the transmission line 121 and the transmission line 132 of the second signal line 13 is still able to share the noise interference that would otherwise be concentrated on the transmission line 132, thereby greatly reducing the interference influence on the transmission line 132 of the second signal line 13 and effectively reducing the crosstalk problem of the communication line.

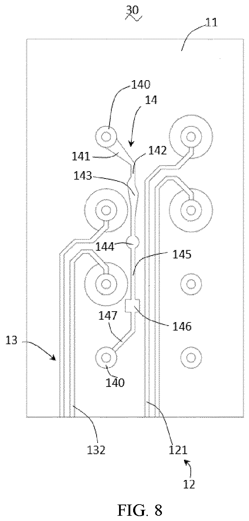

A third embodiment of the present invention relates to still another circuit board 30. As shown in FIG. 8, the circuit board 30 provided in the third embodiment is substantially the same as the circuit board 10 provided in the first embodiment. The circuit board 30 also includes a ground plane 11, a first signal line 12, a second signal line 13, and a conductive layer 14. The difference is that the conductive layer 14 of the third embodiment is not a regular conductor track but a conductive pattern having an irregular shape.

Specifically, the circuit board 30 includes two ground vias 140 and a conductive pattern disposed between the two ground vias 140 and respectively connected to the two ground vias 140. In this embodiment, the conductive pattern includes a trapezoidal portion 141, a rectangular portion 142, a polygonal portion 143, a circular portion 144, a rectangular portion 145, a square portion 146, and a bent portion 147 that are sequentially connected from the ground via 140 at the top of the drawing shown in FIG. 7 to the ground via 140 at the bottom of the drawing shown in FIG. 7. The ground plane 11, the first signal line 12, and the second signal line 13 of the circuit board 30 are the same as those of the first embodiment, and are not repeated herein.

In this way, although the conductive layer 14 has an irregular shape as a whole, it is still able to share the noise interference that would otherwise be concentrated on the transmission line 132, thereby greatly reducing the interference influence on the transmission line 132 of the second signal line 13 and effectively reducing the crosstalk problem of the communication line. It should be appreciated that an irregular design of the conductive layer 14 is not limited to the form provided in this embodiment as long as it is ensured that the conductive layer 14 is electrically connected to the ground plane 11 and disposed between the first signal line 12 and the second signal line 13.

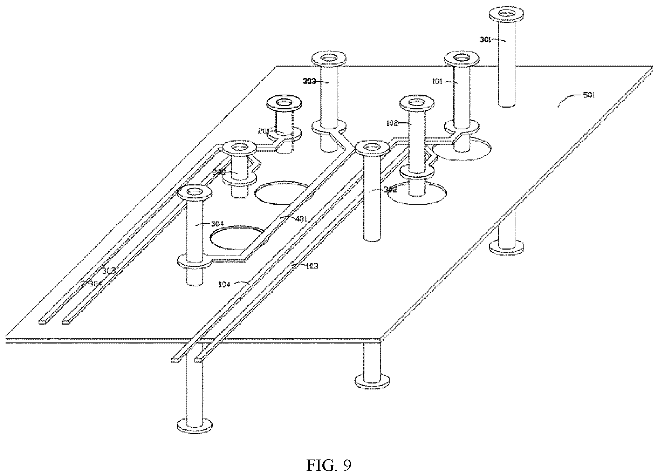

A fourth embodiment of the present invention relates to still another circuit board 40. As shown in FIG. 9, the circuit board 40 provided in the fourth embodiment is substantially the same as the circuit board 10 provided in the first embodiment. The circuit board 40 also includes a ground plane 11, a first signal line 12, a second signal line 13, and a conductive layer 14. The circuit board 40 provided in the fourth embodiment further includes a third signal line 15, and the conductive layer 14 is disposed between the first signal line 12 and the third signal line 15.

Specifically, the third signal line 15 is a conductor track formed inside the circuit board 40, and includes a transmission line 151 and a transmission line 152 that are spaced apart from each other. A transmission line 151 is provided on one side of the signal via 133, and the transmission line 151 is connected to the signal via 133 through a connection line 155. A transmission line 152 is provided on one side of the signal via 134, and the transmission line 152 is connected to the signal via 134 through a connection line 156. Thus, the transmission line 151 and the transmission line 152 communicate with conductor tracks on the other line layers of the circuit board 40 through the signal via 133 and the signal via 134, respectively, to achieve transmission of electrical signals. In this embodiment, both the transmission line 151 and the transmission line 131 are connected to the signal via 133, and both the transmission line 152 and the transmission line 132 are connected to the signal via 134. The transmission line 151 and the transmission line 152 are also differential signal transmission lines, and the transmission line 151 is parallel to the transmission line 152.

It should be noted that the third signal line 15 and the second signal line 13 shown in FIG. 8 are disposed at different layers of the circuit board 40, so that the space is fully utilized in a thickness direction of the circuit board 10, and mutual interference between the second signal line 13 and the third signal line 15 is reduced. In this embodiment, the third signal line 15 is disposed at a layer adjacent to a layer at which the first signal line 12 is disposed (since the conductive layer 14 in the first embodiment is disposed at the same layer as the first signal line 12, the third signal line 15 in this embodiment is also disposed at an adjacent layer of the conductive layer 14). Since the presence of the conductive layer 14 is also able to reduce the degree of interference to which the third signal line 15 is subjected, there is no need to intentionally increase the number of layers spaced between the third signal line 15 and the first signal line 12 due to the interference, thereby reducing the thickness of the circuit board to reduce the cost. In this embodiment, the third signal line 15 faces the second signal line 13 in a thickness direction of the circuit board 40, that is, the third signal line 15 is disposed directly above the second signal line 13.

Since the grounded conductive layer 14 is also disposed between the transmission line 121 of the first signal line 12 and the transmission line 152 of the third signal line 15, a coupling electric field is formed between the transmission line 121 and the grounded conductive layer 14 when the signal propagates on the transmission line 121, so that interference noise generated by the transmission line 121 is transmitted to the conductive layer 14 adjacent to the transmission line 121, and then transmitted to the ground network via the conductive layer 14, so that the conductive layer 14 shares the noise interference that would otherwise be concentrated on the transmission line 152, greatly reduces the interference influence on the transmission line 132 of the third signal line 15, thereby effectively reducing the crosstalk problem of the communication line. In addition, the conductive layer is fully utilized so that it is able to simultaneously reduce the noise interference to both the second signal line 13 and the third signal line 15. It should be appreciated that the first signal line 12 and the second signal line 13 may also be disposed at different layers of the circuit board 40 when the circuit board 40 includes the first signal line 12, the second signal line 13, the conductive layer 14, and the third signal line 15 at the same time. In this embodiment, the third signal line 15 and the second signal line 13 may be disposed at the same layer or different layers of the circuit board 40.

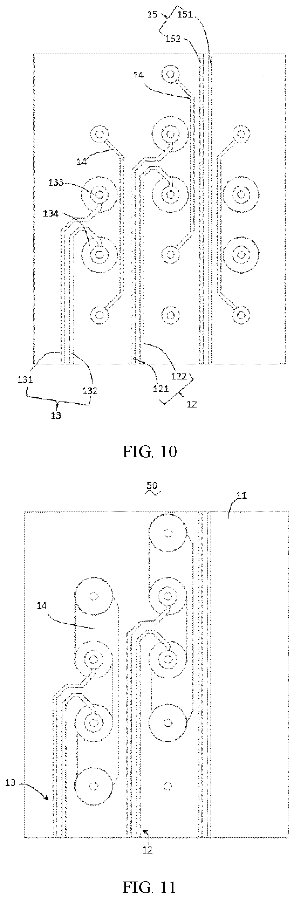

It should be noted that the transmission lines 151, 152 of the third signal line 15 are not limited to be connected to the signal vias 133, 134 in the same manner as the transmission lines 131, 132 as described above. The transmission lines 151 and 152 may also be other signal transmission lines unrelated to the transmission lines 131 and 132, as shown in FIG. 10. Accordingly, the conductive layer 14 is also disposed between the transmission lines 151, 152 and the transmission lines 121, 122 of the first signal line 12.

A fifth embodiment of the present invention relates to still another circuit board 50. As shown in FIG. 11, the circuit board 50 provided in the fifth embodiment is substantially the same as the circuit board 10 provided in the first embodiment. The circuit board 50 also includes a ground plane 11, a first signal line 12, a second signal line 13, and a conductive layer 14. The difference is that the conductive layer 14 of the circuit board 50 provided in the fifth embodiment is not the conductor track but a conductive copper foil disposed between the first signal line 12 and the second signal line 13.

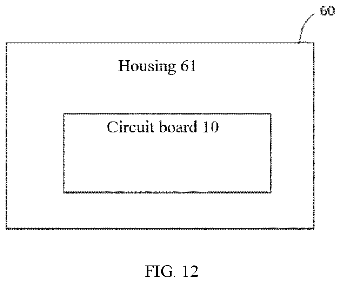

In addition, a sixth embodiment of the present invention further provides a communication device 60 having the circuit board 10, as shown in FIG. 12. The communication device 60 includes a housing 61 and the circuit board 10 accommodated in the housing 61. It should be understood that since the circuit board 10 is able to effectively reduce the communication device, the communication device 60 having the circuit board 10 accordingly has excellent communication quality and effect. It should be understood that the circuit boards 20, 30, 40, 50 in the second, third, fourth, and fifth embodiments may replace the circuit board 10 to be applied in the communication device 60 to effectively reduce the crosstalk problem of the communication line. In addition, the communication device 60 may also include at least two of the circuit boards 10, 20, 30, 40, 50.

Those of ordinary skills in the art should understand that the embodiments described above are specific embodiments of the present invention, and in practical applications, various changes may be made to these embodiments in form and detail without departing from the spirit and scope of the present invention.

## Claims

1. A circuit board, comprising: a first signal line and a second signal line that are disposed adjacent to each other, a ground plane, and a conductive layer connected to the ground plane, wherein the conductive layer is disposed between the first signal line and the second signal line.

2. The circuit board according to claim 1, wherein the first signal line and the conductive layer are disposed at the same layer of the circuit board.

3. The circuit board according to claim 2, wherein the second signal line and the first signal line are disposed at the same layer of the circuit board.

4. The circuit board according to claim 3, wherein the first signal line comprises a first transmission line and a second transmission line that are spaced apart from each other, a first connection line connected to the first transmission line, and a second connection line connected to the second transmission line, wherein a first signal via is provided on one side of the first transmission line, a second signal via is provided on one side of the second transmission line, the first transmission line is connected to the first signal via through the first connection line, and the second transmission line is connected to the second signal via through the second connection line.

5. The circuit board according to claim 4, wherein the second signal line comprises a third transmission line and a fourth transmission line that spaced apart from each other, a third connection line connected to the third transmission line, and a fourth connection line connected to the fourth transmission line, wherein a third signal via is provided on one side of the third transmission line, a fourth signal via is provided on one side of the fourth transmission line, the third transmission line is connected to the third signal via through the third connection line, and the fourth transmission line is connected to the fourth signal via through the fourth connection line.

6. The circuit board according to claim 3, further comprising: a third signal line, wherein the conductive layer is disposed between the first signal line and the third signal line.

7. The circuit board according to claim 6, wherein the third signal line and the second signal line are disposed at different layers of the circuit board.

8. The circuit board according to claim 7, wherein the third signal line faces the second signal line in a thickness direction of the circuit board.

9. The circuit board according to claim 2, wherein the second signal line and the first signal line are disposed at different layers of the circuit board.

10. The circuit board according to claim 9, further comprising: a third signal line, wherein the conductive layer is disposed between the first signal line and the third signal line.

11. The circuit board according to claim 10, wherein the third signal line, the first signal line, and the second signal line are all disposed at different layers of the circuit board.

12. The circuit board according to claim 1, wherein the conductive layer is a conductor track parallel to the first transmission line and the second transmission line.

13. The circuit board according to claim 1, further comprising: a conductive via electrically connected to the ground plane, wherein the conductive layer is electrically connected to the conductive via.

14. A communication device, comprising: a housing and the circuit board according to any one of claims 1 to 13, wherein the circuit board is disposed in the housing.
